# DEMANDE DE BREVET EUROPEEN

(11) **EP 3 657 143 A1**
(43) Date de publication de la demande: **27.05.2020**
(21) Numéro de dépôt: 19210683.9
(22) Date de dépôt: 21.11.2019
(51) Int. Cl.: G01J 5/08

(54) **DETECTEUR THERMIQUE A MEMBRANE SUSPENDUE COMPORTANT UN ABSORBEUR DEFORMABLE**

(30) Priorité: 23.11.2018 FR 1871743
(71) Demandeur: Commissariat à l'Énergie Atomique et aux Énergies Alternatives, 75015 Paris (FR)
(72) Inventeur: ALIANE, Abdelkader, 38054 Grenoble cedex 09 (FR); OUVRIER-BUFFET, Jean-Louis, 38054 Grenoble cedex 09 (FR)
(74) Mandataire: GIE Innovation Competence Group

(57) **Abrégé**

L'invention porte sur un détecteur thermique comportant une structure tridimensionnelle (2) adaptée à détecter un rayonnement électromagnétique, suspendue au-dessus et thermiquement isolée d'un substrat (10), comportant une membrane (20) et un absorbeur (30), celui-ci étant formé à base d'un alliage à mémoire de forme et étant adapté à présenter une configuration plane de détection lorsque sa température est inférieure ou égale à T₁ et une configuration courbe de refroidissement lorsque sa température est supérieure à une température austénitique initiale Aₛ.

## Description

### DOMAINE TECHNIQUE

Le domaine de l'invention est celui de détecteurs thermiques d'un rayonnement électromagnétique, par exemple infrarouge ou térahertz, comportant une membrane suspendue et thermiquement isolée vis-à-vis d'un substrat. L'invention s'applique notamment au domaine de l'imagerie infrarouge ou térahertz, de la thermographie, voire de la détection de personne ou de mouvement.

### ÉTAT DE LA TECHNIQUE ANTÉRIEURE

Les dispositifs de détection de rayonnement électromagnétique peuvent comporter une matrice de pixels sensibles contenant chacun un détecteur thermique comportant une membrane absorbante suspendue au-dessus d'un substrat pouvant contenir un circuit de lecture. La membrane absorbante comporte un absorbeur du rayonnement électromagnétique à détecter associé à un transducteur thermométrique dont une propriété électrique varie en intensité en fonction de l'échauffement du transducteur. Le transducteur thermométrique peut être un matériau thermistance tel qu'un oxyde de vanadium ou du silicium amorphe, entre autres. L'absorbeur est espacé d'un réflecteur disposé au niveau du substrat de manière à former ensemble une cavité interférentielle quart d'onde améliorant l'absorption du rayonnement électromagnétique d'intérêt.

La température du transducteur thermométrique étant cependant grandement dépendante de son environnement, la membrane absorbante est isolée thermiquement du substrat et du circuit de lecture. Ainsi, la membrane absorbante peut être suspendue au-dessus du substrat par des piliers d'ancrage, et est isolée thermiquement du substrat par des bras d'isolation thermique. Ces piliers d'ancrage et bras d'isolation thermique présentent également une fonction électrique en assurant la connexion électrique de la membrane absorbante au circuit de lecture.

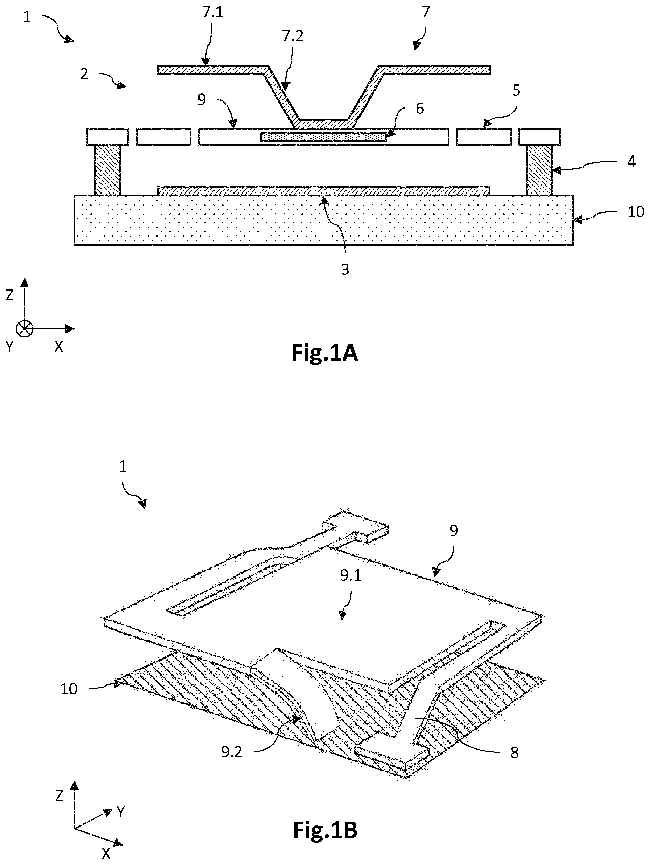

La figure 1A est une vue schématique en coupe d'un détecteur thermique 1 similaire à celui décrit dans l'article de Li et al. intitulé Recent Development of Ultra Small Pixel Uncooled Focal Plane Arrays at DRS, Infrared Technology and Applications XXXIII, Proc. of SPIE, Vol. 6542, 65421Y, 2007. Le détecteur thermique 1 comporte une structure tridimensionnelle 2 suspendue au-dessus du substrat 10 par des piliers d'ancrage 4 et thermiquement isolée de celui-ci par des bras d'isolation thermique 5. La structure tridimensionnelle 2 comporte un étage inférieur formé par une membrane 9 contenant un matériau thermistance 6, ici un oxyde de vanadium, et comporte un étage supérieur formé par un absorbeur 7 du rayonnement infrarouge incident. L'absorbeur 7 s'étend de manière plane au-dessus de la membrane 9, tout en étant en liaison thermique avec le matériau thermistance 6. Plus précisément, l'absorbeur 7 semble être formé de deux parties 7.1, 7.2 réalisées d'un seul tenant et en un même matériau : une partie périphérique supérieure 7.1 qui s'étend de manière planaire au-dessus de la membrane 9, et une partie centrale verticale 7.2 creuse, qui vient reposer sur la membrane 9. Cependant, la présence de la partie centrale verticale 7.2 est susceptible de dégrader les propriétés de la cavité interférentielle quart d'onde et donc de diminuer l'absorption du rayonnement infrarouge incident par l'absorbeur 7.

Par ailleurs, le détecteur thermique est susceptible d'être soumis à un rayonnement électromagnétique de forte puissance, tel qu'un rayonnement solaire ou un rayonnement laser. La membrane absorbante étant isolée thermiquement du substrat, elle peut alors subir un fort échauffement susceptible de provoquer une dégradation des propriétés du transducteur thermométrique.

A ce titre, la figure 1B est une vue schématique en coupe d'un détecteur thermique 1 décrit dans la demande KR101181248. La membrane absorbante 9 est suspendue au-dessus du substrat 10 par des bras 8 d'ancrage et d'isolation thermique. Elle est adaptée à se déformer localement sous l'effet d'un échauffement jusqu'à venir au contact du substrat 10. Ce contact mécanique et donc thermique provoque le refroidissement de la membrane absorbante 9, permettant ainsi d'éviter que la température de celle-ci n'atteigne ou ne dépasse une température seuil Tₜₕ au-delà de laquelle une dégradation des propriétés du matériau thermistance peut avoir lieu. Pour cela, la membrane absorbante 9 comporte une partie fixe de détection 9.1 au niveau de laquelle est disposé le matériau thermistance, et une partie déformable 9.2 de type bilame adaptée à réaliser un court-circuit thermique entre la membrane absorbante 9 et le substrat 10.

Aussi, lors d'un échauffement excessif de la membrane absorbante 9, la partie déformable 9.2 se déforme par effet bilame jusqu'à venir au contact du substrat 10, ce qui provoque le refroidissement de la membrane absorbante 9. Ce refroidissement provoque en retour l'écartement de la partie déformable 9.2 vis-à-vis du substrat 10. Cependant, il apparaît qu'un mouvement continu d'oscillation verticale peut se mettre en place à cause de l'alternance des phases de refroidissement au contact du substrat et de réchauffement après perte du contact, ce qui nuit à la qualité du contact thermique entre la partie déformable 9.2 et le substrat 10, et donc au refroidissement de la membrane absorbante 9.

### EXPOSÉ DE L'INVENTION

L'invention a pour objectif de remédier au moins en partie aux inconvénients de l'art antérieur, et plus particulièrement de proposer un détecteur thermique présentant une absorption du rayonnement électromagnétique d'intérêt améliorée, tout en assurant une bonne protection vis-à-vis des rayonnements électromagnétiques de forte puissance.

Pour cela, l'objet de l'invention est un détecteur thermique adapté à détecter un rayonnement électromagnétique, comportant :
∘ un substrat ;
∘ un réflecteur dudit rayonnement électromagnétique ;
∘ une structure tridimensionnelle adaptée à détecter ledit rayonnement électromagnétique, suspendue au-dessus du substrat et thermiquement isolée du substrat, comportant :
   - une membrane comportant un transducteur thermométrique,
   - un absorbeur dudit rayonnement électromagnétique,
      ▪ reposant sur la membrane et en partie espacé de celle-ci, et en liaison thermique avec le transducteur thermométrique,
      ▪ espacé vis-à-vis du réflecteur de manière à former une cavité interférentielle quart d'onde pour le rayonnement électromagnétique.

Selon l'invention, l'absorbeur est :
- formé à base d'un alliage à mémoire de forme présentant une transformation martensitique dite inverse d'une phase martensitique en une phase austénitique dudit alliage à partir d'une température dite austénitique initiale Aₛ, et
- adapté à présenter :
   ▪ une configuration dite de détection lorsque sa température est inférieure ou égale à une première température seuil T₁, dans laquelle il s'étend de manière planaire dans un plan parallèle au réflecteur, et
   ▪ une configuration dite de refroidissement lorsque sa température est supérieure à une deuxième température seuil T₂ prédéterminée égale à la température austénitique initiale Aₛ, dans laquelle il s'étend au moins en partie de manière courbe vis-à-vis d'un plan parallèle au réflecteur.

Certains aspects préférés mais non limitatifs de ce détecteur thermique sont les suivants.

L'alliage à mémoire de forme présente une fraction volumique χₘ de la phase martensitique. Il peut présenter la configuration plane de détection lorsque la fraction volumique χₘ est supérieure ou égale à 0.95, et peut présenter la configuration courbe de refroidissement lorsque la fraction volumique χₘ est inférieure à 0.95.

L'alliage à mémoire de forme peut présenter une fraction volumique χₘ inférieure ou égale à 0.05 lorsque sa température est supérieure ou égale à une température dite austénitique finale A_{f}, ladite température austénitique finale A_{f} étant inférieure à une température seuil Tₜₕ prédéterminée de protection du transducteur thermométrique.

L'absorbeur déformable peut comporter une partie fixe reposant au contact de la membrane, et une partie libre adaptée à se déformer en fonction de la température de l'absorbeur déformable et s'étendant à partir de la partie fixe en étant espacée de la membrane.

L'alliage à mémoire de forme peut être un alliage métallique à base de NiTi. L'alliage à mémoire de forme peut être un alliage métallique choisi parmi le Ti_{85.3-x}NiₓHf_{14.7} avec x>50%at, le Ti₈₂₋ₓNiₓZr₁₈ avec x>49%at, le Ti₇Ni₁₁Zr₄₃Cu₃₉₋ₓCoₓ avec x>10%at, le Ti₅₀Ni₅₀₋ₓPtₓ avec x< 25%at, le Ti_{50,5}Ni_{24.5}Pd₂₅, le Ti₅₁Ni₃₈Cu₁₁, le Ti₅₀₋ₓNi₅₀Cuₓ avec x>7.5 %at, voire un alliage à base de TiNiCuAlMn.

L'absorbeur déformable peut comporter une couche absorbante en l'alliage à mémoire de forme présentant des protubérances disposées sur une face de la couche absorbante opposée au substrat.

L'absorbeur déformable peut comporter une couche absorbante en l'alliage à mémoire de forme présentant au moins une échancrure formée à partir d'une face de la couche absorbante opposée au substrat.

Le substrat peut présenter une face supérieure plane, et dans lequel la structure tridimensionnelle est maintenue au-dessus de la face supérieure du substrat par des bras d'isolation thermique, et par des piliers d'ancrage qui s'étendent de manière sensiblement orthogonale au plan de la face supérieure du substrat.

Le substrat peut comporter un circuit de lecture, la structure tridimensionnelle étant électriquement connectée au circuit de lecture par les piliers d'ancrage et par les bras d'isolation thermique.

L'invention porte également sur un procédé de fabrication du détecteur thermique selon l'une quelconque des caractéristiques précédentes, comportant les étapes suivantes :
- fourniture d'un substrat ;
- dépôt sur le substrat d'au moins une première couche sacrificielle ;
- réalisation de piliers d'ancrage au travers de la première couche sacrificielle ;
- réalisation de bras d'isolation thermique et d'une membrane contenant un transducteur thermométrique sur la première couche sacrificielle ;
- dépôt d'au moins une deuxième couche sacrificielle de manière à recouvrir les bras d'isolation thermique et la membrane ;
- réalisation de l'absorbeur sur la deuxième couche sacrificielle, de manière à reposer au moins en partie sur la membrane ;
- suppression des première et deuxième couches sacrificielles.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A et 1B, déjà décrites, sont des vues schématiques, en coupe (fig.iA) et en perspective (fig.iB), d'un détecteur thermique selon deux exemples de l'art antérieur ;
les figures 2A et 2B sont des vues schématiques en coupe d'un dispositif de détection selon un mode de réalisation, et la figure 2C est un graphe qui illustre l'évolution en température de la fraction volumique de la phase martensitique au sein d'un alliage à mémoire de forme ;
les figures 3A à 3H illustrent différentes étapes d'un procédé de fabrication du dispositif de détection selon une variante du mode de réalisation illustré sur les fig.2A et 2B ;
les figures 4A et 4B sont des vues schématiques en coupe de différents détecteurs thermiques selon des variantes de réalisation.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, l'expression « comportant un » doit être comprise, sauf indication contraire, comme « comportant au moins un » et non pas comme « comportant un unique ».

L'invention porte sur un dispositif de détection d'un rayonnement électromagnétique, par exemple un rayonnement infrarouge ou térahertz. Le dispositif de détection comporte un ou plusieurs détecteurs thermiques de préférence particulièrement adaptés à détecter un rayonnement infrarouge de la gamme LWIR (*Long Wavelength Infrared,* en anglais) dont la longueur d'onde est comprise entre 8µm et 14µm environ.

Chaque détecteur thermique comporte une structure tridimensionnelle, suspendue au-dessus du substrat, et thermiquement isolée de celui-ci. La structure tridimensionnelle comporte plusieurs étages fonctionnels distincts et superposés les uns aux autres, c'est-à-dire disposés en regard et parallèlement les uns aux autres. Elle comporte ainsi une membrane située dans un étage inférieur et contenant un transducteur thermométrique, et un absorbeur situé dans un étage supérieur. L'absorbeur est adapté à absorber le rayonnement électromagnétique à détecter, et repose sur la membrane tout en étant en partie espacé de celle-ci, et est en liaison thermique avec le transducteur thermométrique.

Chaque détecteur thermique comporte également un réflecteur du rayonnement électromagnétique à détecter, situé de préférence sur le substrat. L'absorbeur est espacé vis-à-vis du réflecteur de manière à former une cavité interférentielle quart d'onde, permettant ainsi d'optimiser l'absorption du rayonnement infrarouge à détecter par l'absorbeur.

Comme détaillé plus loin, l'absorbeur est dit déformable et est adapté à se déformer en fonction de sa température, pour ainsi passer d'une première configuration dite de détection lorsque sa température est inférieure ou égale à une première température seuil T₁ prédéterminée, à une deuxième configuration dite de refroidissement lorsque sa température est supérieure à une deuxième température seuil T₂ prédéterminée, et inversement. Dans la configuration de détection, l'absorbeur s'étend de manière planaire dans un plan parallèle au plan du réflecteur, permettant ainsi de maximiser l'absorption du rayonnement électromagnétique à détecter. Dans la configuration de refroidissement, l'absorbeur s'étend de manière courbe vis-à-vis d'un plan parallèle au plan du réflecteur, minimisant ainsi l'absorption du rayonnement électromagnétique à détecter. Dans la suite de la description, la température T de l'absorbeur déformable est sensiblement égale à la température de la membrane, du fait de la liaison thermique entre ces deux éléments. Aussi, la température est supposée homogène, au premier ordre, au sein de la structure tridimensionnelle, c'est-à-dire tant dans l'absorbeur déformable que dans la membrane à transducteur thermométrique.

Pour cela, l'absorbeur déformable est réalisé à base d'au moins un alliage à mémoire de forme (SMA, pour *Shape Memory Alloy,* en anglais), c'est-à-dire en un alliage présentant une transformation martensitique. Par « à base de », on entend que l'absorbeur déformable comporte majoritairement ledit alliage à mémoire de forme. De manière connue, et comme décrit notamment dans l'article de Choudhary et Kaur intitulé Shape memory alloy thin films and heterostructuresfor MEMS applications: A review, Sensors and Actuators A 242 (2016) 162-181, une transformation martensitique est une transition structurale de l'alliage, réversible et de type displacive, en fonction de la température, entre une phase martensitique (phase cristallographique à basse température) et une phase austénitique (phase cristallographique à haute température). La transformation martensitique présente des températures caractéristiques (à contrainte nulle) qui dépendent du sens de la transformation. Ainsi, pour la transformation directe (austénite en martensite), les températures de début et de fin de transformation sont conventionnellement notées Mₛ (pour *Martensite start temperature,* en anglais) et M_{f} (pour *Martensite finish temperature*). Pour la transformation inverse (martensite en austénite), les températures de début et de fin de transformation sont conventionnellement notées Aₛ (pour *Austenite start temperature*) et A_{f} (pour *Austenite finish temperature*)*.* De manière connue également, la transformation martensitique présente une hystérésis en température entre le refroidissement et l'échauffement de l'alliage, dans la mesure où les températures Mₛ et A_{f} sont différentes l'une de l'autre, tout comme le sont les températures M_{f} et Aₛ.

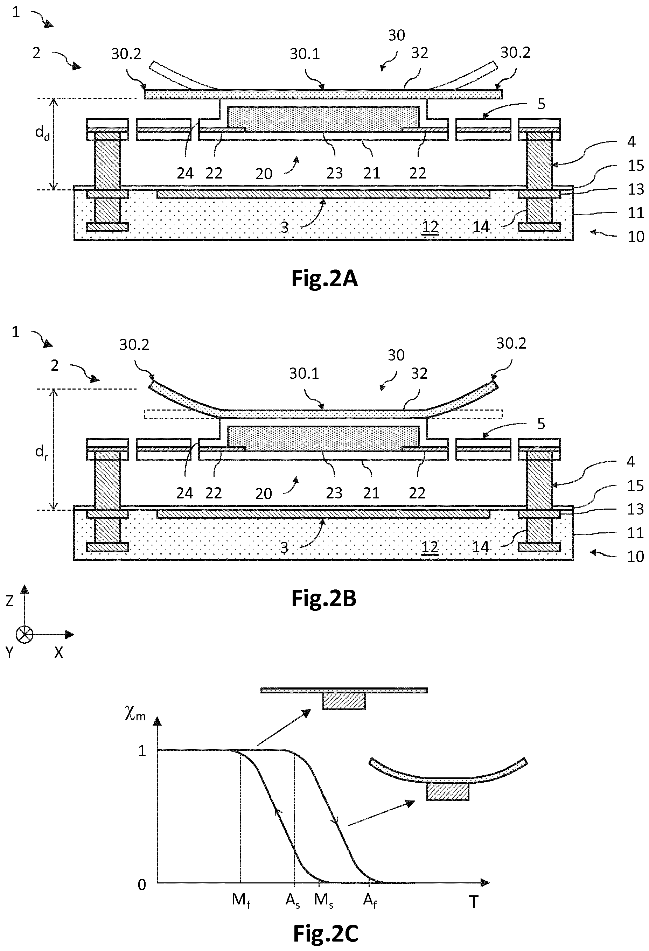

En référence à la figure 2C, lors de la transformation martensitique inverse (de martensite à austénite), la fraction volumique χₘ de la phase martensitique est supérieure ou égale à 0.95, voire égale à 1.0, lorsque la température T de l'alliage à mémoire de forme est inférieure ou égale à la température Aₛ. Elle diminue ensuite à mesure qu'augmente la température T et est inférieure ou égale à 0.05, voire égale à 0, lorsque la température T est supérieure ou égale à la température A_{f}. De même, lors de la transformation martensitique directe (de austénite à martensite), la fraction volumique χₘ de la phase martensitique est inférieure ou égale à 0.05, voire égale à 0, lorsque la température T de l'alliage à mémoire de forme est supérieure ou égale à la température Mₛ. Elle augmente ensuite à mesure que diminue la température T et est supérieure ou égale à 0.95, voire égale à 1.0, lorsque la température T est inférieure ou égale à la température M_{f}.

Dans le cadre de l'invention, l'absorbeur déformable à base d'un alliage à mémoire de forme présente une température austénitique initiale Aₛ égale à la deuxième température seuil T₂ (à partir de laquelle l'absorbeur se courbe). Ainsi, il se déforme en fonction de sa température et peut ainsi présenter :
∘ une forme plane (configuration de détection) lorsque sa température T est inférieure ou égale à la première température seuil T₁, laquelle est égale à la température martensitique finale M_{f} ou à la température austénitique initiale Aₛ, en fonction du sens, direct ou inverse, de la transformation martensitique, et
∘ une forme courbe (configuration de refroidissement) lorsque sa température T est supérieure à la température austénitique initiale Aₛ.

Ainsi, comme présenté en détail plus loin, l'effet de seuil associé à la déformation de l'alliage à mémoire de forme est mis à profit pour minimiser les risques de dégradation du transducteur thermométrique liés à un échauffement excessif, tout en optimisant l'absorption du rayonnement électromagnétique d'intérêt en l'absence d'un tel échauffement excessif.

Les figures 2A et 2B sont des vues schématiques en coupe d'un détecteur thermique 1 selon un mode de réalisation, comportant un absorbeur déformable 30 en configuration plane de détection (fig.2A) et en configuration courbe de refroidissement (fig.2B). Un seul détecteur thermique 1 est ici représenté, mais le dispositif de détection comporte avantageusement une matrice de détecteurs thermiques identiques (pixels sensibles). Le détecteur thermique 1 peut présenter des dimensions latérales dans le plan XY (dites pas pixel), de l'ordre d'une à quelques dizaines de microns, par exemple égale à 10µm environ voire moins.

On définit ici et pour la suite de la description un repère direct tridimensionnel orthogonal (X,Y,Z), où le plan (X,Y) est sensiblement parallèle au plan principal du substrat de lecture 10 du détecteur thermique 1, et où l'axe Z est orienté suivant une direction sensiblement orthogonale au plan principal du substrat de lecture 10 et orientée vers la structure tridimensionnelle 2. Dans la suite de la description, les termes « inférieur » et « supérieur » s'entendent comme étant relatifs à un positionnement croissant lorsqu'on s'éloigne du substrat de lecture 10 suivant la direction +Z.

Le détecteur thermique 1 comporte un substrat avantageusement fonctionnalisé, dit substrat de lecture 10, réalisé dans cet exemple à base de silicium, comportant un circuit de lecture permettant la commande et la lecture des détecteurs thermiques. Le circuit de lecture se présente ici sous la forme d'un circuit intégré CMOS situé dans un substrat support 11. Il comporte des portions 13 de lignes conductrices, par exemple métalliques, séparées les unes des autres par un matériau diélectrique 12, par exemple un matériau minéral à base de silicium tel qu'un oxyde de silicium SiOₓ, un nitrure de silicium SiNₓ, ou leurs alliages. Il peut également comporter des éléments électroniques actifs (non représentés), par exemple des diodes, transistors, ou des éléments électroniques passifs, par exemple des condensateurs, résistances..., connectés par des interconnexions électriques au détecteur thermique 1 d'une part, et à un plot de connexion (non représenté) d'autre part, ce dernier étant destiné à connecter le dispositif de détection à un dispositif électronique externe. A titre illustratif, les portions conductrices 13 et les vias conducteurs 14 peuvent être réalisés, par exemple, en cuivre, en aluminium ou en tungstène. Le cuivre ou le tungstène peut éventuellement être situé entre des sous-couches en nitrure de titane, de tantale ou autre. Le substrat de lecture 10 présente ici une face supérieure 10a formée notamment par une surface d'une couche isolante inter-métal 12 et une surface de portions conductrices 13 du dernier niveau d'interconnexion électrique.

Le détecteur thermique 1 comporte un réflecteur 3, réalisée au moins un matériau réfléchissant vis-à-vis du rayonnement électromagnétique à détecter. Il est ici avantageusement formé d'une portion de la ligne conductrice du dernier niveau d'interconnexion électrique du circuit intégré CMOS. Il est situé ici dans le substrat 10 et participe à définir la face supérieure 10a du substrat. En variante, il peut reposer sur la face supérieure 10a du substrat, voire être espacé de celle-ci d'une distance non nulle.

La face supérieure 10a est avantageusement revêtue d'une couche de protection 15, notamment lorsque le détecteur thermique 1 est réalisé via l'utilisation de couches sacrificielles minérales éliminées ensuite par attaque chimique en milieu acide HF (acide fluorhydrique). La couche de protection 15 présente alors une fonction d'arrêt de gravure, et est donc adaptée à assurer une protection du substrat support 11 et des couches diélectriques inter-métal 12, lorsqu'elles sont réalisées en un matériau minéral, vis-à-vis de l'attaque chimique HF. Cette couche de protection 15 forme ainsi une couche hermétique et chimiquement inerte. Elle est électriquement isolante pour éviter tout court-circuit entre les portions 13 de ligne métallique. Elle peut ainsi être réalisée en alumine Al₂O₃, voire en nitrure ou fluorure d'aluminium, voire en silicium amorphe intrinsèque. Elle peut présenter une épaisseur comprise entre quelques dizaines et quelques centaines de nanomètres, par exemple comprise entre 10nm et 500nm, de préférence comprise entre 20nm et 100nm.

Le détecteur thermique 1 comporte une structure tridimensionnelle 2 adaptée à détecter le rayonnement électromagnétique d'intérêt, suspendue au-dessus du substrat 10 par les piliers d'ancrage 4 et isolée thermiquement de celui-ci par des bras d'isolation thermique 5. La structure tridimensionnelle 2 est de plus électriquement connectée au circuit de lecture par les piliers d'ancrage 4 et les bras d'isolation thermique 5.

Les piliers d'ancrage 4 sont des plots conducteurs réalisés en au moins un matériau électriquement conducteur, qui s'étendent suivant l'axe Z à partir du substrat de lecture 10 jusqu'à la structure tridimensionnelle 2. Ils sont au contact des portions 13 de lignes conductrices, et assurent ainsi la connexion électrique de la structure tridimensionnelle 2 au circuit de lecture. Les piliers d'ancrage 4 peuvent être réalisés, par exemple, en cuivre, en aluminium ou en tungstène, éventuellement encapsulé dans au moins une sous-couche de protection en nitrure de titane, ou autre. Les bras d'isolation thermique 5 s'étendent ici de manière sensiblement coplanaire à la membrane 20, et sont ici formés d'une couche électriquement conductrice permettant la connexion électrique de la membrane 20 au circuit de lecture, avantageusement encapsulée dans deux couches diélectriques inférieure et supérieure qui participent à assurer la rigidification des bras d'isolation thermique 5.

La structure tridimensionnelle 2 comporte deux étages fonctionnels distincts superposés l'un à l'autre. Les étages fonctionnels sont ainsi disposés dans des plans distincts et parallèles entre eux, et sont en regard l'un de l'autre.

Le premier étage fonctionnel est un étage inférieur présentant une fonction de détection du rayonnement électromagnétique. Pour cela, il comporte la membrane 20 contenant un transducteur thermométrique 23, c'est-à-dire un élément présentant une propriété électrique variant avec son échauffement. La membrane 20 s'étend de manière planaire parallèlement au plan XY du substrat 10. Elle est dite fixe dans la mesure où elle est située à une distance sensiblement constante vis-à-vis du substrat 10. Le transducteur thermométrique 23 est ici un matériau thermistance comme par exemple un oxyde de vanadium ou de titane, ou du silicium amorphe, mais peut être en variante une capacité formée par un matériau pyroélectrique ou ferroélectrique, une diode (jonction pn ou pin), voire un transistor à effet de champ et à structure métal/oxyde/semiconducteur (MOSFET).

La membrane 20 est ici classiquement formée d'un empilement d'une couche diélectrique inférieure 21 réalisée en un matériau diélectrique, de deux électrodes 22 électriquement isolées l'une de l'autre par un espacement latéral, d'un matériau thermistance 23 s'étendant au contact des électrodes de polarisation 22 et de la couche diélectrique inférieure 21, et d'une couche diélectrique supérieure 24 recouvrant les électrodes de polarisation 22 et le matériau thermistance 23, permettant notamment de protéger le matériau thermistance 23 lors de l'attaque chimique à l'acide fluorhydrique mise en œuvre ultérieurement.

Le deuxième étage fonctionnel est un étage supérieur présentant une fonction d'absorption du rayonnement électromagnétique à détecter. Il comporte ainsi l'absorbeur déformable 30, réalisé à base d'un alliage à mémoire de forme avantageusement adapté à absorber le rayonnement électromagnétique. Il repose sur la membrane 20 et est en liaison thermique avec le matériau thermistance 23, tout en étant en partie espacé de celle-ci. L'absorbeur déformable 30 est ainsi adapté à se déformer en fonction de sa température et ainsi à passer d'une configuration plane de détection à une configuration courbe de refroidissement, et inversement.

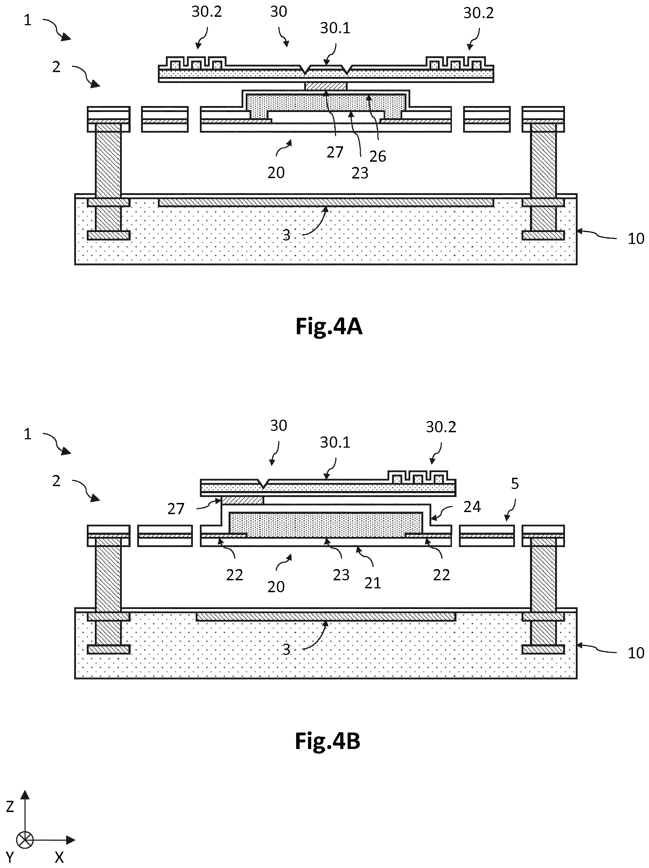

L'absorbeur déformable 30 est formé d'une partie fixe 30.1, reposant au contact de la membrane 20, ici de la couche supérieure de protection, et d'une partie dite libre 30.2, c'est-à-dire apte à se déformer et espacée de la membrane 20 d'une distance non nulle. Dans cet exemple, la partie fixe 30.1 est située au centre de l'absorbeur déformable 30, et la partie libre 30.2 s'étend de manière périphérique autour de la partie fixe 30.1. En variante (cf. figure 4B), la partie fixe 30.1 peut être située en bordure de l'absorbeur déformable 30, et la partie libre 30.2 peut alors s'étendre à partir de la partie fixe 30.1 suivant une ou deux directions privilégiées.

En référence à la fig.2A, l'absorbeur déformable 30 est adapté à occuper une configuration de détection dans laquelle il s'étend de manière planaire parallèlement au plan XY du substrat. L'absorbeur déformable 30 peut occuper la configuration plane de détection lorsque l'alliage à mémoire de forme présente une fraction volumique χₘ de la phase martensitique supérieure ou égale à 0.95, par exemple égale à 1.0, c'est-à-dire lorsque sa température est inférieure ou égale à une première température seuil T₁, à savoir la température martensitique finale M_{f} ou la température austénitique initiale Aₛ selon le sens direct ou inverse de la transformation martensitique.

Dans la configuration plane de détection, l'absorbeur déformable 30 est planaire, de sorte que sa partie fixe 30.1 et sa partie libre 30.2 sont espacées du réflecteur 3 d'une distance non nulle d_{d} sensiblement constante et homogène dans le plan XY. La distance d_{d} est donc constante en température tant que T est inférieure ou égale à T₁. Cette distance est ajustée de manière à former une cavité interférentielle quart d'onde non perturbée maximisant l'absorption du rayonnement électromagnétique à détecter par l'absorbeur déformable 30. L'absorbeur déformable 30 est espacé du réflecteur 3 d'une distance typiquement comprise entre 1µm et 5µm, de préférence 2µm, lorsque le détecteur thermique 1 est conçu pour la détection d'un rayonnement infrarouge compris dans le LWIR. Aussi, l'absorbeur déformable 30, dans la configuration plane de détection, permet de maximiser l'absorption du rayonnement électromagnétique d'intérêt.

En référence à la fig.2B, l'absorbeur déformable 30 est adapté à occuper une configuration de refroidissement pour laquelle l'absorbeur s'étend de manière courbe vis-à-vis d'un plan parallèle au plan XY du substrat. Il peut occuper la configuration courbe de refroidissement lorsque l'alliage à mémoire de forme présente une fraction volumique χₘ de la phase martensitique inférieure à 0.95, par exemple égale à 0.5 ou moins, c'est-à-dire lorsque sa température est supérieure à une deuxième température seuil T₂ prédéterminée, à savoir ici la température austénitique initiale Aₛ.

Dans la configuration courbe de refroidissement, l'absorbeur déformable 30 est courbe, de sorte que sa partie fixe 30.1 est espacée du réflecteur 3 de la distance d_{d} mais que la partie libre 30.2 déformée est espacée du réflecteur 3 d'une distance non nulle variable dᵣ dans le plan XY, dont la valeur dépend de la température T. Cette distance dᵣ ne correspond alors plus à la distance d_{d} de sorte que la cavité interférentielle quart d'onde est dégradée. L'absorption du rayonnement électromagnétique par l'absorbeur déformable 30, dans la configuration courbe de refroidissement, est alors diminuée, ce qui permet de réduire l'échauffement de l'absorbeur déformable 30 et donc de diminuer sa température ainsi que celle du matériau thermistance 23.

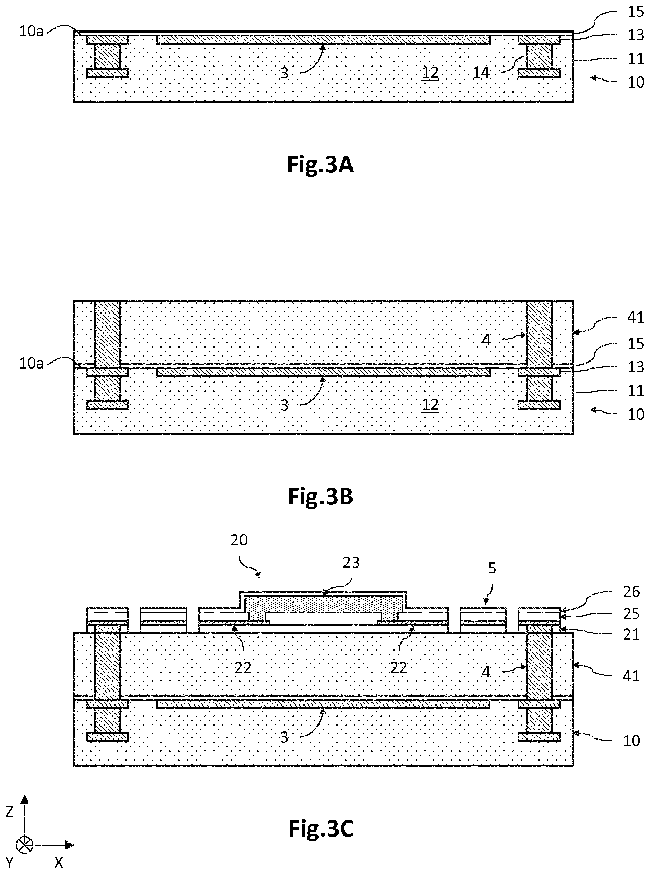

L'absorbeur déformable 30 est réalisé à base d'un alliage à mémoire de forme. Il est formé d'une couche absorbante 32 en l'alliage à mémoire de forme, ici avantageusement encapsulé entre deux couches inférieure et supérieure de protection (cf. fig.3A-3H). Les couches de protection sont destinées à protéger notamment l'alliage à mémoire de forme lors d'une phase de suppression des couches sacrificielles utilisées lors de la fabrication du détecteur thermique 1. Elles peuvent être réalisées par exemple en un nitrure de silicium SiN ou un oxyde de silicium SiO, par exemple d'une épaisseur de 10nm.

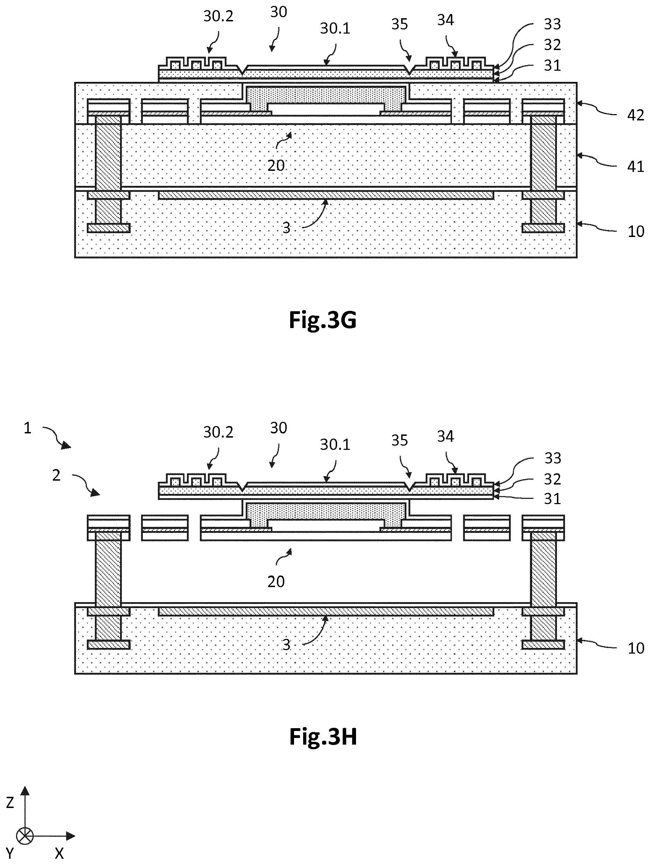

D'une manière générale, l'alliage à mémoire de forme est un alliage métallique choisi parmi les alliages à base de NiTi, à base de cuivre Cu, ou à base de fer Fe. L'alliage métallique est choisi de sorte que la température austénitique initiale Aₛ est égale à la température T₂, laquelle est inférieure ou égale à une température prédéterminée Tₜₕ de protection du transducteur thermométrique. Cette température de protection dépend du type de transducteur thermométrique, et peut être de l'ordre de 100°C à 350°C, par exemple à 200°C. Ainsi, l'alliage métallique peut être réalisé en un composé binaire NiTi avec une proportion atomique de nickel et de titane égale ou non, ou en un composé ternaire NiTiA où l'élément chimique additionnel A peut être du fer Fe, du cuivre Cu, du zirconium Zr, de l'hafnium Hf, du platine Pt, du palladium Pd, du tungstène W, de l'or Au, ou autre. Il peut ainsi s'agir du Ti₅₁Ni₃₈Cu₁₁ où les indices représentent la proportion atomique de chaque élément chimique au sein de l'alliage. On peut citer par exemple : Ti_{85.3-x}NiₓHf_{14.7} avec x>50% en at.%, Ti₈₂₋ₓNiₓZr₁₈ avec x>49% en at.%, Ti₇Ni₁₁Zr₄₃Cu₃₉₋ₓCoₓ avec x>10% en at.%, Ti₅₀Ni₅₀₋ₓPtₓ avec x< 25% en at.%, Ti_{50,5}Ni_{24.5}Pd₂₅, Ti₅₁Ni₃₈Cu₁₁, Ti₅₀₋ₓNi₅₀Cuₓ avec x>7.5 % en at.%. Il peut également s'agir d'un alliage à base de TiNiCuAlMn dont la température austénitique initiale est inférieure ou égale à 200°C. Ces alliages présentent une résistivité comprise entre 10⁻⁶ Ω.m et 4.10⁻⁵ Ω.m. L'épaisseur de la couche absorbante 32 en l'alliage en mémoire de forme est telle que son impédance est sensiblement égale à celle du vide (résistance de la couche absorbante proche de 377 Ω/sq) et peut être comprise entre quelques nanomètres à quelques dizaines de nanomètres, par exemple compris entre 5nm et 25nm. De préférence, l'alliage métallique est le Ti₅₀₋ₓNi₅₀Cuₓ (résistivité 1.5x10⁻⁶ Ω.m) d'épaisseur entre 4nm et 6nm, et le Ti_{85.3-x}NiₓHf_{14.7} (résistivité 2x10⁻⁶ Ω.m) d'épaisseur comprise entre 5nm et 10nm. Plus précisément, comme mentionné ci-dessous, la couche absorbante 32 en l'alliage à mémoire de forme présente avantageusement une épaisseur constante dans la partie fixe 30.1 et la partie libre 30.2. Elle peut cependant comporter des protubérances 34 (cf. fig.3H) situées au niveau de la partie libre 30.2, et/ou au moins une échancrure 35 (cf. fig.3H) située à la jointure entre la partie fixe 30.1 et la partie libre 30.2.

La couche absorbante 32 en l'alliage à mémoire de forme de l'absorbeur déformable 30 comporte avantageusement une variation locale d'épaisseur, de manière à contrôler plus efficacement le sens de la déformation entre les configurations plane et courbe. Autrement dit, pour obtenir une déformation de l'absorbeur déformable 30 telle que la distance dᵣ en configuration courbe de refroidissement est supérieure à la distance d_{d} en configuration plane de détection, la couche absorbante 32 en l'alliage à mémoire de forme comporte au moins un motif en saillie 34 (cf. fig.3H), c'est-à-dire au moins une protubérance, situé sur une face de l'absorbeur déformable 30 opposée au substrat 10. Ces protubérances 34 peuvent s'étendre de manière orthogonale à la surface locale de l'absorbeur déformable 30, et peuvent présenter une hauteur par exemple de l'ordre de quelques dizaines nanomètres. En variante ou en complément, l'absorbeur déformable 30 peut également comporter au moins une échancrure 35 (cf. fig.3H) située à la jointure entre la partie fixe 30.1 et la partie mobile, au niveau de la face de l'absorbeur déformable 30 opposée au substrat 10. Une échancrure 35 est une diminution locale de l'épaisseur de la couche absorbante 32 en l'alliage à mémoire de forme, qui reste non nulle.

De préférence, l'absorbeur déformable 30 est réalisé en un alliage à mémoire de forme présentant une constante de temps dynamique Δt_{dyn} de déformation, en réponse à l'absorption du rayonnement électromagnétique de forte puissance, qui est inférieure à une constante de temps thermique Δtₜₕ associée à l'échauffement excessif provoqué par ce rayonnement. Autrement dit, lorsque le détecteur thermique 1 reçoit le rayonnement électromagnétique de forte puissance, l'absorbeur déformable 30 se déforme et passe de la configuration plane de détection à la configuration courbe de refroidissement, ce qui provoque un dérèglement de la cavité interférentielle quart d'onde et donc une dégradation de l'absorption du rayonnement électromagnétique, et donc une diminution de la température T de l'absorbeur déformable 30, avant que la température T n'atteigne la température seuil Tₜₕ de protection du matériau thermistance 23. Pour cela, l'alliage à mémoire de forme est avantageusement choisi parmi, par exemple, le Ti_{85.3-x}NiₓHf_{14.7} avec x>50% en at.%, le Ti₅₀₋ₓNi₅₀Cuₓ avec x>7.5 % en at.%, le Ti₈₂₋ₓNiₓZr₁₈ avec x>49% en at.%, le Ti_{50,5}Ni_{24.5}Pd₂₅, entre autres.

Ainsi, l'absorbeur déformable 30 à base d'un alliage à mémoire de forme permet d'améliorer la protection du détecteur thermique 1, et plus précisément du transducteur thermométrique 23, lorsque celui-ci est soumis à un rayonnement électromagnétique de forte puissance.

En effet, en l'absence d'un tel rayonnement électromagnétique, la température T de l'absorbeur déformable 30 est égale à une température nominale, laquelle est inférieure ou égale à la température austénitique initiale Aₛ. L'absorbeur déformable 30 présente ainsi une configuration plane de détection, dans laquelle il s'étend de manière sensiblement planaire en regard du réflecteur 3. La cavité interférentielle quart d'onde est ainsi non dégradée, ce qui permet de maximiser l'absorption du rayonnement électromagnétique d'intérêt par l'absorbeur déformable 30.

Lorsqu'un rayonnement électromagnétique de forte puissance est présent, par exemple un rayonnement solaire ou un faisceau laser, la température T de l'absorbeur déformable 30 augmente et devient supérieure à la température austénitique initiale Aₛ. L'absorbeur déformable 30 passe ainsi de la configuration plane de détection à la configuration courbe de refroidissement, dans laquelle il s'étend de manière sensiblement courbe vis-à-vis du plan XY parallèle au réflecteur 3. Les propriétés de la cavité interférentielle quart d'onde sont alors dégradées, ce qui provoque une diminution de l'absorption du rayonnement électromagnétique de forte puissance par l'absorbeur déformable 30, et conduit à une diminution de la température T.

Ainsi, l'effet de seuil lié à la transformation martensitique inverse d'un alliage à mémoire de forme est ainsi mis à profit pour protéger le détecteur thermique 1 vis-à-vis d'un échauffement excessif, tout en gardant une cavité interférentielle quart d'onde non dégradée en l'absence d'un tel rayonnement électromagnétique de forte puissance.

Les figures 3A à 3H illustrent différentes étapes d'un procédé de fabrication d'un détecteur thermique 1 selon un autre mode de réalisation. Dans cet exemple, le détecteur thermique 1 est réalisé en utilisant des couches sacrificielles minérales destinées à être ultérieurement supprimées par gravure humide en milieu acide (HF vapeur). En variante, les couches sacrificielles peuvent être réalisées à base de polyimide ou équivalent et être ultérieurement supprimées par gravure sèche par exemple sous plasma 02. Dans ce cas, les matériaux des couches de protection 31, 33 sont adaptés à être inertes à ce type de gravure sèche, et peuvent être choisis parmi l'AlN, le Al₂O₃, le carbone amorphe, le silicium amorphe, entre autres.

En référence à la fig.3A, on réalise le substrat de lecture 10, formé d'un substrat support 11 contenant le circuit de lecture adapté à commander et lire le détecteur thermique 1. Le circuit de lecture comporte ainsi des portions conductrices 13 qui affleurent la face supérieure 10a du substrat de lecture 10, laquelle est sensiblement plane. Les portions conductrices 13 et les vias conducteurs 14 peuvent être réalisés en cuivre, en aluminium et/ou en tungstène, entre autres, par exemple au moyen d'un procédé damascène dans lequel on remplit des tranchées réalisées dans la couche isolante inter-métal. L'affleurement des portions conductrices 13 au niveau de la face supérieure 10a peut être obtenu par une technique de planarisation mécano-chimique (CMP).

On réalise également le réflecteur 3 du détecteur thermique 1. Le réflecteur 3 est ici formé par une portion d'une ligne conductrice du dernier niveau d'interconnexion, celle-ci étant réalisée en un matériau métallique adapté à réfléchir le rayonnement électromagnétique à détecter. Il est destiné à s'étendre en regard de la membrane 20, et est destiné à former avec l'absorbeur déformable 30 une cavité interférentielle quart d'onde vis-à-vis du rayonnement électromagnétique à détecter.

On peut ensuite déposer une couche de protection 15 de manière à recouvrir la couche isolante inter-métal 12. Cette couche d'arrêt de gravure 15 est réalisée en un matériau sensiblement inerte à l'agent de gravure utilisé ultérieurement pour supprimer les couches sacrificielles minérales, par exemple au milieu HF en phase vapeur. Elle permet ainsi d'éviter que les couches isolantes minérales 12 sous-jacentes ne soient gravées lors de cette étape de suppression des couches sacrificielles. Elle peut être formée en un oxyde ou nitrure d'aluminium, en trifluorure d'aluminium, ou en silicium amorphe intrinsèque (non intentionnellement dopé). Elle peut être déposée par exemple par PVD (pour *Physical Vapor Deposition,* en anglais) et peut présenter une épaisseur de l'ordre d'une dizaine de nanomètres à quelques centaines de nanomètres.

En référence à la fig.3B, on réalise des piliers d'ancrage 4. Pour cela, on dépose une première couche sacrificielle 41 sur le substrat de lecture 10, par exemple réalisée en un matériau minéral tel qu'un oxyde de silicium SiOₓ déposé par dépôt chimique en phase vapeur assisté par plasma (PECVD). Ce matériau minéral est apte à être supprimé par gravure chimique humide, en particulier par attaque chimique en milieu acide, l'agent de gravure étant de préférence de l'acide fluorhydrique (HF) en phase vapeur. Cette couche sacrificielle minérale 41 est déposée de manière à s'étendre continûment sur sensiblement toute la surface du substrat de lecture 10 et recouvrir ainsi la couche d'arrêt de gravure 15. L'épaisseur de la couche sacrificielle 41 suivant l'axe Z permet de définir la hauteur de la membrane 20. Elle peut être de l'ordre de quelques centaines de nanomètres à quelques microns.

On réalise ensuite des orifices verticaux destinés à la formation des piliers d'ancrage 4. Ils sont réalisés par photolithographie et gravure, et traversent la couche sacrificielle minérale 41 et la couche de protection 15, pour déboucher sur les portions conductrices 13 du circuit de lecture. Les orifices verticaux peuvent présenter une section droite dans le plan (X,Y) de forme carrée, rectangulaire, ou circulaire, d'une surface sensiblement égale, par exemple, à 0,25µm². On réalise ensuite les piliers d'ancrage 4 dans les orifices verticaux. Ils peuvent être réalisés par remplissage des orifices par un ou plusieurs matériaux électriquement conducteurs. A titre d'exemple, ils peuvent comporter chacun une couche de TiN déposée par PVD ou MOCVD (pour Métal Organic Chemical Vapor Déposition, en anglais) sur les flancs verticaux des orifices, et un cœur en cuivre ou en tungstène remplissant l'espace délimité transversalement par la couche de TiN. Une étape de CMP permet ensuite de supprimer les matériaux de remplissage en excès et de planariser la face supérieure formée par la couche sacrificielle 41 et les piliers d'ancrage 4.

En référence à la fig.3C, on réalise les bras d'isolation thermique 5 et la membrane 20 à transducteur thermométrique, ici une membrane 20 à thermistance. Les bras d'isolation thermique 5 assurent l'isolation thermique de la membrane 20 vis-à-vis du substrat de lecture 10, la connexion électrique du matériau thermistance 23, et participent à maintenir la membrane 20 suspendue au-dessus du substrat de lecture 10. Pour cela, on dépose ici une couche diélectrique inférieure 21 sur la couche sacrificielle 41, puis une couche conductrice 22 et une couche diélectrique intermédiaire 25. Le contact électrique entre les piliers d'ancrage 4 et la couche conductrice 22 est obtenu par des ouvertures pratiquées au préalable au travers de la couche diélectrique inférieure 21 et remplie par le matériau de la couche conductrice 22. La couche conductrice 22 est ainsi en contact avec l'extrémité supérieure des piliers d'ancrage 4. Elle est réalisée en un matériau électriquement conducteur, par exemple du TiN d'une épaisseur de quelques nanomètres à quelques dizaines de nanomètres, par exemple 10nm. Les couches diélectriques inférieure 21 et intermédiaire 25 peuvent être réalisées en silicium amorphe, carbure de silicium, alumine Al₂O₃ ou nitrure d'aluminium, entre autres. Elles peuvent présenter une épaisseur de quelques dizaines de nanomètres, par exemple 20nm, et participent à assurer la rigidification des bras d'isolation thermique 5.

La membrane 20 à thermistance est formée d'un empilement ici de la couche isolante inférieure 21, de deux électrodes 22 issues de la couche conductrice et isolées l'une de l'autre par un espacement latéral, de la couche isolante intermédiaire 25 recouvrant les électrodes de polarisation 22 et l'espacement latéral, hormis en deux ouvertures débouchant sur les électrodes 22, d'un matériau thermistance 23, par exemple du silicium amorphe ou un oxyde de vanadium ou de titane. Le matériau thermistance 23 est au contact des deux électrodes 22 via les ouvertures. Une couche supérieure de protection 26 est ensuite déposée de manière à recouvrir le matériau thermistance 23 et éventuellement la couche diélectrique intermédiaire 25 au niveau des bras d'isolation thermique 5. Elle permet de protéger le matériau thermistance 23 vis-à-vis de l'agent de gravure chimique utilisé lors de la suppression ultérieure des couches sacrificielles minérales. Une structuration des couches diélectriques 21, 25, de la couche conductrice 22, et de la couche supérieure de protection 26 est ensuite effectuée par photolithographie et gravure localisée, de manière à définir les bras d'isolation thermique 5 dans le plan XY, ainsi que la membrane 20 à thermistance. La structure de la membrane 20 est donnée ici à titre illustratif, et d'autres structures peuvent être utilisées.

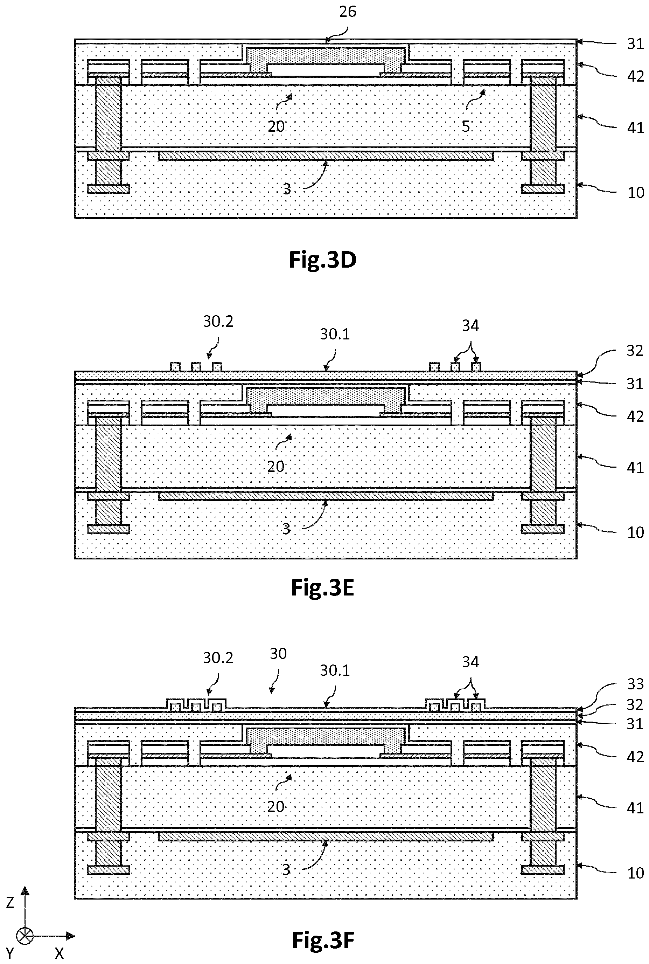

En référence à la figure 3D, on dépose ensuite une deuxième couche sacrificielle 42 puis une deuxième couche inférieure de protection 31. La deuxième couche sacrificielle 42 recouvre ainsi la membrane 20 à thermistance ainsi que les bras d'isolation thermique 5. Une étape de CMP peut être effectuée de sorte que la face supérieure de la couche sacrificielle 42 affleure au niveau de celle de la couche supérieure de protection 26. La couche sacrificielle 42 est réalisée de préférence en un matériau identique à celui de la première couche sacrificielle 41. On dépose ensuite la couche inférieure de protection 31 de manière à recouvrir la deuxième couche sacrificielle 42. Elle est réalisée de préférence en un matériau permettant de protéger l'alliage à mémoire de forme lors d'une étape ultérieure de suppression des couches sacrificielles. Elle peut être réalisée en un nitrure ou un oxyde de silicium, d'une épaisseur par exemple de 10nm.

En référence à la figure 3E, on dépose ensuite une couche absorbante 32 en alliage à mémoire de forme. La couche absorbante 32 est déposée de manière à recouvrir la couche inférieure de protection 31. Elle présente une épaisseur constante au niveau des parties fixe et libre, choisie de manière à adapter son impédance à celle du vide. L'épaisseur peut ainsi être comprise entre 5nm et 25nm, par exemple. L'alliage à mémoire de forme peut être un alliage métallique de NiTi dont la proportion atomique de nickel et de titane, ainsi que d'éventuels éléments chimiques additionnels, permet d'obtenir une température austénitique initiale Aₛ égale à la température T₂ et inférieure à une température seuil de protection Tₜₕ. L'alliage à mémoire de forme peut ainsi être choisi parmi le Ti_{85.3-x}NiₓHf_{14.7} avec x>50% en at.%, le Ti₈₂₋ₓNiₓZr₁₈ avec x>49% en at.%, le Ti₇Ni₁₁Zr₄₃Cu₃₉₋ₓCoₓ avec x>10% en at.%, le Ti₅₀Ni₅₀₋ₓPtₓ avec x< 25% en at.%, le Ti_{50,5}Ni_{24.5}Pd₂₅, le Ti₅₁Ni₃₈Cu₁₁, le Ti₅₀₋ₓNi₅₀Cuₓ avec x>7.5 % en at.%, voire un alliage de la famille TiNiCuAlMn. Ensuite, on réalise avantageusement des motifs en saillie 34, c'est-à-dire des protubérances, en l'alliage à mémoire de forme. Ces protubérances 34 sont disposées au niveau d'une face de la couche absorbante 32 opposée au substrat 10 et sont situées dans une zone destinée à former la partie libre 30.2. Elles peuvent s'étendre, continûment ou non, autour de la partie fixe 30.1. Aussi, les zones destinées à former les parties fixe 30.1 et libre 30.2 présentent une épaisseur sensiblement constante, hormis au niveau des protubérances 34. L'épaisseur des protubérances 34 peut être de l'ordre de 5nm à 100nm, et de préférence être comprise entre 10nm et 50nm.

En référence à la figure 3F, on dépose ensuite une deuxième couche supérieure de protection 33, de manière à recouvrir continûment la couche absorbante 32 en l'alliage à mémoire de forme. La couche supérieure de protection 33 s'étend donc sur les zones destinées à former les parties fixe 30.1 et libre 30.2, et recouvre les protubérances 34. Elle est réalisée de préférence en un matériau et une épaisseur identiques à ceux de la couche inférieure de protection 31.

En référence à la figure 3G, on structure ensuite l'empilement des couches inférieure 31 et supérieure 33 de protection, ainsi que la couche absorbante 32, par photolithographie et gravure, de manière à former l'absorbeur déformable 30 disposé en regard du réflecteur 3. L'absorbeur déformable 30 comporte ainsi une partie fixe 30.1 reposant au contact de la membrane 20, et une partie 30.2 ici périphérique destinée à être libre, c'est-à-dire apte à se déformer en fonction de sa température. De manière à améliorer l'obtention de la déformation suivant la direction +Z de la partie libre 30.2 lorsque la température de l'absorbeur déformable 30 dépasse la température Aₛ, on réalise avantageusement une échancrure 35, par gravure partielle de la couche absorbante 32 et de la couche supérieure de protection 33, située à la jointure entre la partie fixe 30.1 et la partie libre 30.2. En variante, l'échancrure 35 peut être réalisée avant le dépôt de la couche supérieure de protection 33.

En référence à la fig.3H, on supprime les différentes couches sacrificielles 41, 42 de manière à suspendre la structure tridimensionnelle 2, et donc la membrane 20 au-dessus du substrat de lecture 10, et la partie libre 30.2 de l'absorbeur déformable 30 au-dessus de la membrane 20. La suspension peut être effectuée après avoir réalisé l'encapsulation du détecteur thermique 1 dans un boîtier (non représenté) définissant une cavité sous vide destinée à être hermétique. La suspension peut être obtenue par gravure chimique des différentes couches sacrificielles minérales 41, 42, ici par une gravure chimique humide par attaque à l'acide fluorhydrique en phase vapeur.

On obtient ainsi un détecteur thermique 1 comportant une structure tridimensionnelle 2 formée d'un étage inférieur contenant la membrane 20 à thermistance, et un étage supérieur contenant l'absorbeur déformable 30. Celui-ci est formé à base d'un alliage à mémoire de forme qui permet d'assurer la déformation de l'absorbeur déformable 30 et d'absorber le rayonnement électromagnétique d'intérêt. Il comporte une partie fixe 30.1 qui repose au contact de la membrane 20 à thermistance, et une partie libre 30.2 qui est espacée de celle-ci. Ainsi, en deçà de la température austénitique initiale Aₛ, l'absorbeur déformable 30 présente une configuration plane de détection, dans laquelle il est espacé du réflecteur 3 de la distance constante d_{d} dans le plan XY. La cavité interférentielle quart d'onde est alors non perturbée, ce qui maximise l'absorption du rayonnement électromagnétique d'intérêt par l'absorbeur déformable 30. Au-delà de cette température Aₛ, l'absorbeur déformable 30 présente une configuration courbe de refroidissement dans laquelle la partie libre 30.2 est espacée du réflecteur 3 d'une distance dᵣ différente de la valeur d_{d}. La cavité interférentielle quart d'onde est alors perturbée, ce qui diminue l'absorption du rayonnement électromagnétique de forte puissance par l'absorbeur déformable 30 et provoque son refroidissement et donc celui de la membrane 20 à thermistance. Le détecteur thermique 1 présente ainsi une protection améliorée vis-à-vis des rayonnements électromagnétiques de forte puissance, tout en optimisant l'absorption du rayonnement électromagnétique d'intérêt en l'absence d'échauffement excessif.

De plus, dans la mesure où l'alliage à mémoire de forme présente une constante de temps dynamique Δt_{day} avantageusement inférieure à la constante de temps thermique Δtₜₕ associée à l'échauffement de l'absorbeur déformable 30 lorsqu'il est soumis au rayonnement électromagnétique de forte puissance, l'alliage à mémoire de forme se déforme et passe rapidement de la configuration plane de détection à la configuration courbe de refroidissement, limitant ainsi tout échauffement excessif de l'absorbeur déformable 30 et donc de la membrane 20 à thermistance, et donc tout risque de dégradation du matériau thermistance 23. Aussi, il y a refroidissement de la membrane 20 à thermistance avant que la température de celle-ci n'atteigne ou ne dépasse la température seuil de protection Tₜₕ du matériau thermistance 23.

Des modes de réalisation particuliers viennent d'être décrits. Différentes variantes et modifications apparaîtront à l'homme du métier.

Ainsi, la figure 4A illustre une variante de réalisation qui se distingue du mode de réalisation illustré sur la fig.3H essentiellement en ce que la membrane 20 comporte une portion intercalaire 27 qui repose sur le matériau thermistance 23, ici sur la couche supérieure de protection 26. La portion intercalaire 27 est réalisée en un matériau thermiquement conducteur. Elle est ici située au centre de la membrane 20 et ici au centre du matériau thermistance 23. Elle présente une face supérieure formant la surface support pour l'absorbeur déformable 30. La surface support présente une étendue inférieure à celle de la couche supérieure de protection 26 au niveau du matériau thermistance 23. L'absorbeur déformable 30 présente alors une longueur de déformation, dans le plan XY, plus importante que s'il reposait au contact de la couche supérieure de protection 26. Ainsi, l'absorbeur déformable 30, dans la configuration courbe de refroidissement, présente une partie libre 30.2, adaptée à se déformer, qui s'étend de manière périphérique autour d'une partie fixe 30.1 qui repose sur la portion intercalaire 27. La partie libre 30.2 présente une surface dans le plan XY plus importante, ce qui conduit à perturber la cavité interférentielle quart d'onde sur une plus grande zone dans le plan XY, et donc conduit à une diminution plus importante de l'absorption du rayonnement électromagnétique d'intérêt, et donc de la température de l'absorbeur déformable 30.

La figure 4B illustre schématiquement une autre variante, qui se distingue de celle illustrée sur la fig.4A essentiellement en ce que la portion intercalaire 27 est située en bordure du matériau thermistance 23. Aussi, l'absorbeur déformable 30 comporte une partie libre 30.2, adaptée à se déformer, située en regard du matériau thermistance 23, qui s'étend dans le plan XY à partir de la partie fixe 30.1.

Par ailleurs, la fig.4B illustre un autre exemple de structure de la membrane 20. Dans cet exemple, la membrane 20 ne comporte pas de couche diélectrique intermédiaire située entre le matériau thermistance 23 et les électrodes de polarisation 22. Elle comporte ainsi une couche diélectrique inférieure 21, réalisée en un matériau diélectrique par exemple en un oxyde de silicium, un nitrure de silicium ou un oxynitrure de silicium. Elle peut aussi être réalisée en un matériau semiconducteur présentant une résistivité électrique inférieure aux matériaux diélectriques, mais présentant une plus faible conductivité thermique, comme du silicium amorphe de haute résistivité électrique. A titre d'exemple, pour un matériau thermistance 23 de résistivité électrique de 10Ω.cm et d'une épaisseur de 80nm, la couche diélectrique inférieure 21 peut être réalisée en silicium amorphe d'une épaisseur de 40nm et d'une résistivité électrique supérieure ou égale à 1000Ω.cm. D'une manière générale, la couche diélectrique inférieure 21 présente une épaisseur par exemple comprise entre 10nm et 100nm, de préférence comprise entre 30nm et 50nm. Elle participe à assurer la rigidification des bras d'isolation thermique 5.

Deux électrodes de polarisation 22 s'étendent de manière plane sur la couche diélectrique inférieure 21 et au contact de celle-ci. Elles sont espacées l'une de l'autre d'un espacement latéral par exemple de l'ordre de 5µm à 10µm pour un pas pixel de l'ordre de 12µm, de manière à éviter de shunter électriquement le matériau thermistance 23. Le matériau thermistance 23 repose au contact des électrodes de polarisation 22, et repose au contact de la couche diélectrique inférieure 21. Une couche diélectrique supérieure 24 recouvre le matériau thermistance 23 et les électrodes de polarisation 22. Elle présente de préférence un matériau identique ou similaire à celui de la couche diélectrique inférieure 21, et présente de préférence une épaisseur identique. Elle participe avantageusement à la rigidification des bras d'isolation thermique 5. Cet exemple de membrane 20 est donné à titre illustratif, et d'autres structures peuvent être utilisées.

## Revendications

1. Détecteur thermique (1) adapté à détecter un rayonnement électromagnétique, comportant :
∘ un substrat (10) ;
∘ un réflecteur (3) dudit rayonnement électromagnétique ;
∘ une structure tridimensionnelle (2) adaptée à détecter ledit rayonnement électromagnétique, suspendue au-dessus du substrat (10) et thermiquement isolée du substrat (10), comportant :
• une membrane (20) comportant un transducteur thermométrique (23),
• un absorbeur (30) dudit rayonnement électromagnétique,
▪ reposant sur la membrane (20) et en partie espacé de celle-ci, et en liaison thermique avec le transducteur thermométrique (23),
▪ espacé vis-à-vis du réflecteur (3) de manière à former une cavité interférentielle quart d'onde pour le rayonnement électromagnétique,
**caractérisé en ce que** l'absorbeur (30) est :
• formé à base d'un alliage à mémoire de forme présentant une transformation martensitique dite inverse d'une phase martensitique en une phase austénitique dudit alliage à partir d'une température dite austénitique initiale Aₛ, et
• adapté à présenter :
▪ une configuration dite de détection lorsque sa température est inférieure ou égale à une première température seuil T₁ (M_{f} ; Aₛ), dans laquelle il s'étend de manière planaire dans un plan parallèle au réflecteur (3), et
▪ une configuration dite de refroidissement lorsque sa température est supérieure à une deuxième température seuil T₂ prédéterminée égale à la température austénitique initiale Aₛ, dans laquelle il s'étend au moins en partie de manière courbe vis-à-vis d'un plan parallèle au réflecteur (3).

2. Détecteur thermique (1) selon la revendication 1, dans lequel l'alliage à mémoire de forme présente une fraction volumique χₘ de la phase martensitique, et présente la configuration plane de détection lorsque la fraction volumique χₘ est supérieure ou égale à 0.95, et présente la configuration courbe de refroidissement lorsque la fraction volumique χₘ est inférieure à 0.95.

3. Détecteur thermique (1) selon la revendication 1 ou 2, dans lequel l'alliage à mémoire de forme présente une fraction volumique χₘ de la phase martensitique, et présente une fraction volumique χₘ inférieure ou égale à 0.05 lorsque sa température est supérieure ou égale à une température dite austénitique finale A_{f}, ladite température austénitique finale A_{f} étant inférieure à une température seuil Tₜₕ prédéterminée de protection du transducteur thermométrique.

4. Détecteur thermique (1) selon l'une quelconque des revendications 1 à 3, dans lequel l'absorbeur déformable (30) comporte une partie fixe (30.1) reposant au contact de la membrane (20), et une partie libre (30.2) adaptée à se déformer en fonction de la température de l'absorbeur déformable (30) et s'étendant à partir de la partie fixe (30.1) en étant espacée de la membrane (20).

5. Détecteur thermique (1) selon l'une quelconque des revendications 1 à 4, dans lequel l'alliage à mémoire de forme est un alliage métallique à base de NiTi.

6. Détecteur thermique (1) selon l'une quelconque des revendications 1 à 5, dans lequel l'alliage à mémoire de forme est un alliage métallique choisi parmi le Ti_{85.3-x}NiₓHf_{14.7} avec x>50%at, le Ti₈₂₋ₓNiₓZr₁₈ avec x>49%at, le Ti₇Ni₁₁Zr₄₃Cu₃₉₋ₓCoₓ avec x>10%at, le Ti₅₀Ni₅₀₋ₓPtₓ avec x< 25%at, le Ti_{50,5}Ni_{24.5}Pd₂₅, le Ti₅₁Ni₃₈Cu₁₁, le Ti₅₀₋ₓNi₅₀Cuₓ avec x>7.5 %at, voire un alliage à base de TiNiCuAlMn.

7. Détecteur thermique (1) selon l'une quelconque des revendications 1 à 6, dans lequel l'absorbeur déformable (30) comporte une couche absorbante (32) en l'alliage à mémoire de forme présentant des protubérances (34) disposées sur une face de la couche absorbante (32) opposée au substrat (10).

8. Détecteur thermique (1) selon l'une quelconque des revendications 1 à 7, dans lequel l'absorbeur déformable (30) comporte une couche absorbante (32) en l'alliage à mémoire de forme présentant au moins une échancrure (35) formée à partir d'une face de la couche absorbante (32) opposée au substrat (10).

9. Détecteur thermique (1) selon l'une quelconque des revendications 1 à 8, dans lequel le substrat (10) présente une face supérieure (10a) plane, et dans lequel la structure tridimensionnelle (2) est maintenue au-dessus de la face supérieure (10a) du substrat (10) par des bras d'isolation thermique (5), et par des piliers d'ancrage (4) qui s'étendent de manière sensiblement orthogonale au plan de la face supérieure (10a) du substrat (10).

10. Détecteur thermique (1) selon la revendication 9, dans lequel le substrat (10) comporte un circuit de lecture, la structure tridimensionnelle (2) étant électriquement connectée au circuit de lecture par les piliers d'ancrage (4) et par les bras d'isolation thermique (5).

11. Procédé de fabrication du détecteur thermique (1) selon l'une quelconque des revendications précédentes, comportant les étapes suivantes :
- fourniture d'un substrat (10) ;
- dépôt sur le substrat (10) d'au moins une première couche sacrificielle (41) ;
- réalisation de piliers d'ancrage (4) au travers de la première couche sacrificielle (41) ;
- réalisation de bras d'isolation thermique (5) et d'une membrane (20) contenant un transducteur thermométrique (23) sur la première couche sacrificielle (41) ;
- dépôt d'au moins une deuxième couche sacrificielle (42) de manière à recouvrir les bras d'isolation thermique (5) et la membrane (20) ;
- réalisation de l'absorbeur (30) sur la deuxième couche sacrificielle (42), de manière à reposer au moins en partie sur la membrane (20) ;
- suppression des première et deuxième couches sacrificielles (41, 42).
